# EUROPEAN PATENT APPLICATION

(11) **EP 2 503 594 A1**
(43) Date of publication of application: **26.09.2012**
(21) Application number: 11368010.2
(22) Date of filing: 21.03.2011
(51) Int. Cl.: H01L 23/498

(54) **Signal routing optimized IC package ball/pad layout**

(71) Applicant: Dialog Semiconductor GmbH, 73230 Kirchheim/Teck-Nabern (DE)
(72) Inventor: Petersen, Holger, 85669 Pastetten (DE)
(74) Representative: Schuffenecker, Thierry

(57) **Abstract**

This invention provides layout schemes for ball/pad regions on a printed circuit board for a small regular ball/pad region grid that provides additional space between ball/pad regions for increased wiring capability. The layout scheme is consistent with printed circuit board manufacturing requirements and minimum wiring channel requirements demanded by high density integrated circuit chips.

## Description

### Technical field

This invention relates to a compressed ball/pad region layout grid or matrix for printed circuit boards which will carry integrated circuits and possibly other circuit components. The layout allows spacing for conductors and accommodates high density spacing for integrated circuit pads.

### Background Art

U.S. Pat. No. 7,652,379 B2 to Poddar describes a bond pad stack having two conductor layers below a third conductor layer. The third conductor layer has a width that is greater than the width of each of the two conductor layers below the third layer.

U.S. Pat. No. 7,495,296 B2 to Maeda et al. describes a layout of a multichannel semiconductor integrated circuit having ternary circuits in order to increase the degree of integration.

U.S. Pat. No. 6,168,854 B1 to Gibbs describes a method of manufacturing printed circuit boards having high density conductive patterns comprising at least one pad suitable for forming a solder connection with at least one surface mounted component. A process is also described which applies a resist to a conductive pattern, etching the conducting pattern, and using the resist to form a conducting coating on the conducting pattern.

U.S. Pat. No. 6,057,601 to Lau et al. describes a semiconductor ball grid array package for integrated circuits which have input and output counts higher than 250. The package includes a supporting heat spreader layer having a plurality of saw teeth to penetrate an adhesive layer covering a plurality of ground planes. These ground planes are formed on a backside of a substrate supporting a semiconductor device such that the heat spreader can function as a ground terminal for the semiconductor device.

U.S. Pat. No. 5,818,114 to Pendse et al. describes a radially staggered bonding pad arrangement around the center of a semiconductor die. The bonding pad arrangement allows for increased lead frame density used for wire bonding conductors between the semiconductor circuit pads and the staggered bonding pad arrangement.

U.S. Pat. No. 5,567,655 to Rostoker et al. describes a bond pad layout on semiconductor circuit chips which reduces thermally induced mechanical stresses. The bond pads are equidistant from the centerline of the chip. Bond pads on either side of the centerline are staggered.

### Summary of the invention

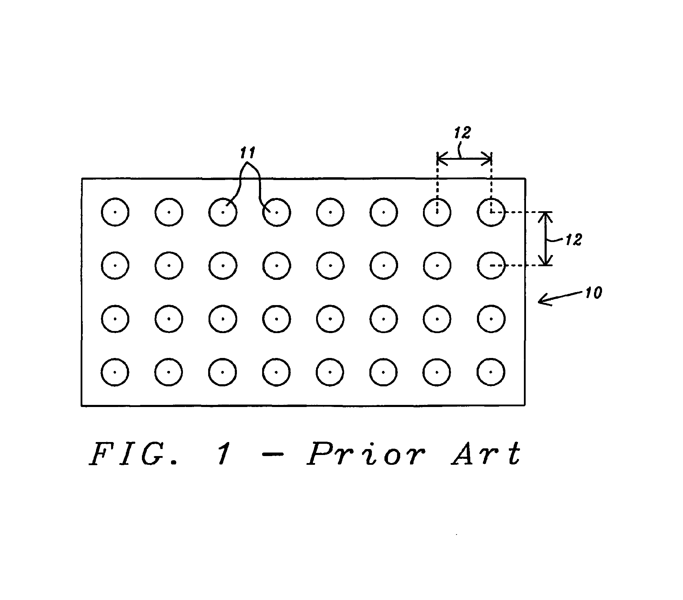

Today's standard IC (integrated circuit) package ball/pad region layout is defined by a regular pitch in the x and y direction, as shown in Fig. 1. Fig. 1 shows a top view of a standard integrated circuit board 10 having a number of ball/ pad regions 11. The pitch 12 is the same in the x and y directions and is determined by the number of required ball/pad regions and the target package size. Typically manufacturing rules require a minimum pitch for a given manufacturing technology. As the density of circuits in integrated circuit chips increases and the size of the chips decreases more wiring channels are required. Smaller pitch is a serious limitation to the availability of sufficient wiring channels.

ICs with a single outside row and/or column of balls/pads may be routed on a PCB (printed circuit board) using a single outer layer of metal. To route ICs with a higher number of rows/columns the PCBs typically have to use multiple layers of metal. Inner rows/columns are then routed on the outside layer only towards a close placed via, which then allows a further signal routing inside a deeper PCB layer. Vias are drilled holes with a layer of copper at the circumference. Standard vias are mechanically drilled and have a typical minimum hole diameter of 200-300um. Because of mechanical tolerances the connected landing pads of standard vias are typically ≥ 550um.

Following the trend for miniaturization and reduced PCB space the ball/pad pitch of ICs with a higher level of integration has been reduced from 0.8mm and 0.65mm towards 0.5mm and 0.4mm with plans to go even towards 0.3mm. This has created some challenges for the signal routing on the PCB. But from 0.5mm pitch standard vias can no longer be placed between balls/pads. For about 0.4mm or smaller ball/pad pitch it is no longer possible to route signals between regular spaced balls/pad regions.

It is a principal objective of this invention to provide a ball/pad layout scheme that meets manufacturing requirements for a small regular ball/pad region grid and provides additional space between ball/pad regions for increased wiring capability.

This objective is achieved by using a different x and y ball/pad pitches in local areas of the integrated circuit package. A staggered ball/pad region pitch arrangement is used to achieve a reduced pitch in one direction while maintaining a minimum ball to ball (pad to pad) distance. A ball/pad region pitch of about 0.5 mm can be used in the x direction and a pitch of about 0.32 mm in the y direction with alternating rows locating balls/pads at the gaps of adjacent rows. This provides a spacing of about 0.4mm between nearest balls/pads in adjacent rows. A different ball/pad region pitch can be used in other regions of the integrated circuit package.

### Description of the drawings

Fig. 1 shows a top view of a printed circuit board having a standard x-y grid of ball/pad regions.
Fig. 2 shows a top view of a printed circuit board of this invention showing four rows of an x-y ball/pad region grid using a first pitch in the x direction, the top row and bottom row having a one half first pitch off-set in the x direction, a second pitch in the y direction between the top row and the adjacent row and the bottom row and the adjacent row, and a third pitch between the two middle rows.
Fig. 3 shows a top view of a printed circuit board of this invention showing four rows of an x-y ball/pad region grid having a different pitch in the x and y directions with every second row having a one half pitch offset in the x direction.
Fig. 4 shows a top view of a printed circuit board of this invention showing a ball/pad region grid of the type shown in Fig. 3 at the four edges of the printed circuit board with larger spacing between the ball/pad regions in the center of the board.
Fig. 5 shows a top view of the printed circuit board shown in Fig. 4 showing placement of standard vias in the board.

### Description of the preferred embodiments

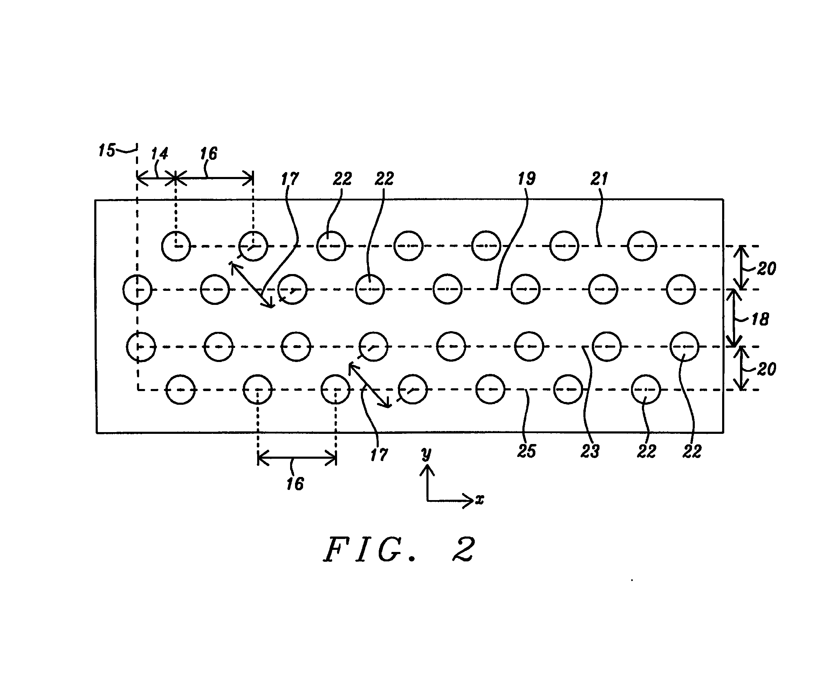

Refer now to Fig 2 for a description of a preferred embodiment of the ball/pad region layout of this invention. Fig. 2 shows a top view of a printed circuit board of this invention showing four rows of an x-y grid for locating the ball/pad regions 22. The ball/pad regions 22 have a pitch of a first distance 16 in the x direction for all four rows and the top row and bottom row have an off-set 14 of one half of the first distance 16 in the x direction. The distance in the y direction between the centerline 21 of the ball/pad regions 22 in the top row and the centerline 19 of the ball/pad regions 22 in the next row and between the centerline 25 of the ball pad regions 22 bottom row and the centerline 23 of the ball/pad regions in the next to last row is a pitch of a second distance 20. The distance between the centerlines 19 and 23 of the ball/pad regions in the two middle rows is a pitch of a third distance 18. The distance between the ball/pad regions in the first row and the nearest neighbor ball/pad regions in the second row and between the ball/pad regions in the last row and the nearest neighbor ball/pad regions in the next to last row is a pitch of a fourth distance 17 In this example the first distance 16 is about 0.5mm, the second distance 20 is about 0.32mm, and the third distance 18 is about 0.4mm. This provides a fourth distance 17 of about 0.4mm which in this example is about the same as the third distance. Of course, different values for the first, second, and third distances could be used which would result in a different fourth distance. The location of the left most ball/pad regions are on a reference line 15.

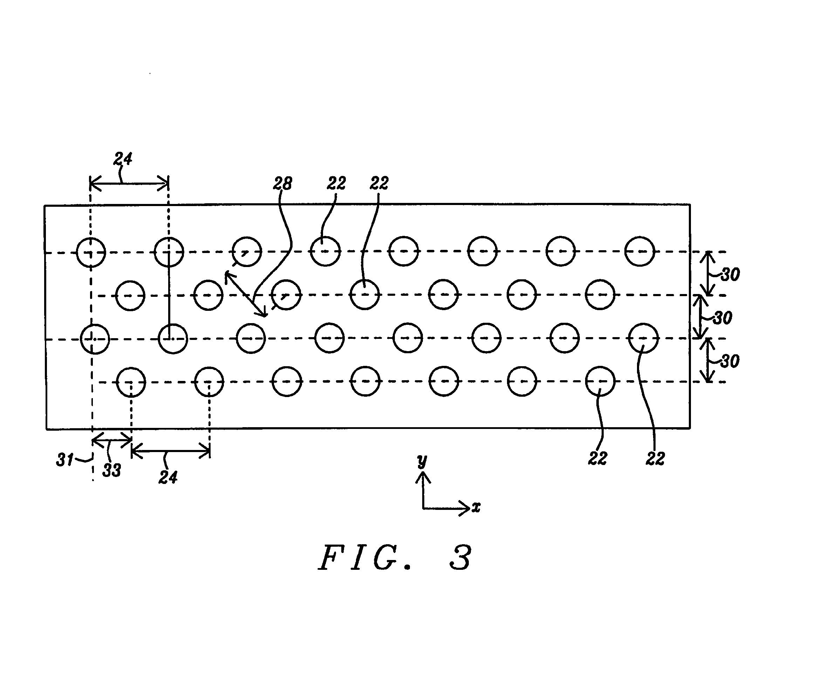

Refer now to Fig. 3 for another preferred embodiment of the ball/pad region layout of this invention. Fig. 3 shows a top view of a printed circuit board of this invention showing four rows of an x-y grid for locating the ball/pad regions 22. The ball/pad regions 22 have a first pitch in the x direction of a first distance 24 for all four rows. The second row and bottom row have an off-set in the x direction of a second distance 33, which is one half of the first distance 24. The pitch of the centerlines of the ball/pad regions in the y direction have a second pitch of a second distance 30. This results in a separation between nearest neighbor ball/pad regions of a third distance 28. As an example a first distance 24 of about 0.5 mm and a second distance 30 of about 0.32 mm results in a third distance 28 of about 0.41 mm. The location of the left most ball/pad regions are on a reference line 31.

Those skilled in the art will readily recognize that different values for the first distance 24 and second distance 30 can be used, which will provide a different third distance 28 for separation between nearest neighbor ball/pad regions. For example a first distance 24 of 0.58 mm and a second distance 30 of 0.29 mm results in a third distance 28 of about 0.41 mm.

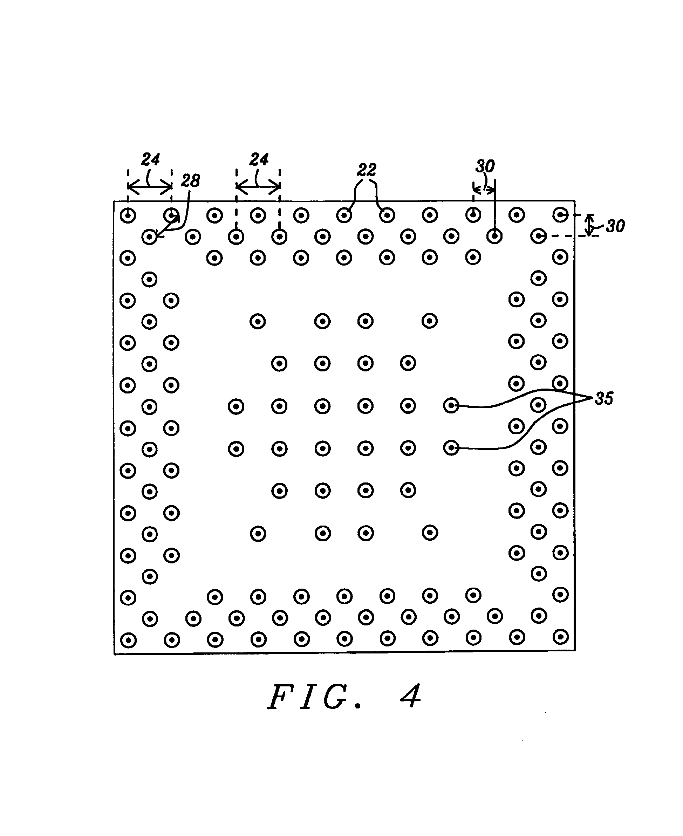

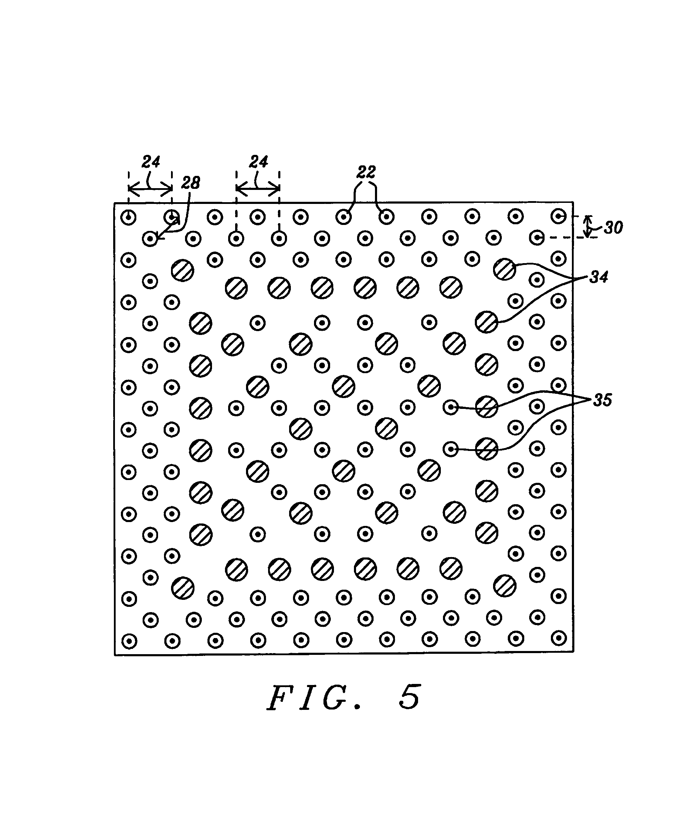

Fig. 4 shows another embodiment of the ball/pad region layout of this invention. Fig. 4 shows a top view of a printed circuit board 37 having a ball/pad region layout as described in a previous paragraph and shown in Fig. 3 around the four edges of the printed circuit board. In the regions around the four edges of the printed circuit board like reference numbers identify like features of the invention as described above and shown in Fig. 3. Fig. 4 also shows ball/pad regions 35 on a more widely spaced grid at the center portion of the printed circuit board. Fig. 5 shows the printed circuit board of Fig. 4 also showing the placement of standard vias 35.

While the invention has been particularly shown and described with reference to the preferred embodiments thereof, it will be understood by those skilled in the art that various changes in form and details may be made without departing from the spirit and scope of the invention.

## Claims

1. A ball/pad region layout pattern, comprising:
- a circuit board for supporting circuit components and conductive circuit patterns, wherein said circuit board has a plurality of ball/pad regions;
- an x-y grid for location of said ball/pad regions, wherein said x and y directions are perpendicular;
- a reference line parallel to said y direction;
- one or more first rows of conductive ball/pad regions formed on said circuit board wherein the centers of said ball/pad regions in said first rows are on a straight line parallel to said x direction, each said ball/pad region has a center, said centers of each of said ball/pad regions in each of said first rows are located one half of a first distance plus N multiplied by said first distance from said reference line, and wherein N is zero or a positive integer of one or greater; and
- one or more second rows of conductive ball/pad regions formed on said circuit board wherein the centers of said ball/pad regions in said second rows are on a straight line parallel to said x direction, each said ball/pad region has a center, said centers of each of said ball/pad regions in each of said second rows are located M multiplied said first distance from said reference line, M is zero or a positive integer of one or greater, and wherein each said first row is adjacent to and a second distance from one of said second rows and each said second row is adjacent to and said second distance from one of said first rows and adjacent to and a third distance from one of said second rows.

2. The ball/pad region layout of claim 1 wherein said third distance is about 0.4 millimeters.

3. A ball/pad region layout pattern, comprising:
- a circuit board for supporting circuit components and conductive circuit patterns, wherein said circuit board has a plurality of ball/pad regions;
- an x-y grid for location of said ball/pad regions, wherein said x and y directions are perpendicular;
- a reference line parallel to said y direction;
- one or more first rows of conductive ball/pad regions formed on said circuit board wherein the centers of said ball/pad regions in said first rows are on a straight line parallel to said x direction, each said ball/pad region has a center, said centers of each of said ball/pad regions in each of said first rows are located N multiplied by a first distance from said reference line, and wherein N is positive integer of zero, one, or greater; and
- one or more second rows of conductive ball/pad regions formed on said circuit board wherein the centers of said ball/pad regions in said second rows are on a straight line parallel to said x direction, each said ball/pad region has a center, said centers of each of said ball/pad regions in each of said second rows are located one half of said first distance plus M multiplied by said first distance from said reference line, wherein M is a positive integer of zero, one, or greater, and wherein each said first row is adjacent to and a second distance from at one or two of said second rows and each said second row is adjacent to and said second distance from one or two of said first rows.

4. The ball/pad region layout of claim 1 or 3 wherein said circuit components comprise integrated circuit devices.

5. The ball/pad region layout of claim 1 or 3 wherein said ball/pad regions are circular.

6. The ball/pad region layout of claim 1 or 3 wherein said first distance is about 0.5 millimeters.

7. The ball/pad region layout of claim 1 or 3 wherein said second distance is about 0.32 millimeters.

8. The ball/pad region layout of claim 1 or 33 wherein said first distance is about 0.58 millimeters and said second distance is about 0.29mm.

9. The ball/pad region layout of claim 1 or 3 wherein there are two said first rows and two said second rows and said first and second rows are arranged consecutively in said y direction as one of said first rows, one of said second rows, one of said first rows, and one of said second rows.

10. The ball/pad region layout of claim 1 or 3 wherein said circuit board may have different regions with different said ball/pad layouts.

11. The ball/pad region layout of claim 1 or 3 wherein said circuit board is a printed circuit board.

12. The ball/pad region layout of claim 1 or 3 wherein said circuit board also has vias.
